(19) Europäisches Patentamt
European Patent Office
Office européen des brevets

(11) EP 2 121 860 B1

(12) **EUROPEAN PATENT SPECIFICATION**

(45) Date of publication and mention of the grant of the patent:
**25.01.2012 Bulletin 2012/04**

(21) Application number: **07822403.7**

(22) Date of filing: **09.11.2007**

(51) Int Cl.:
***C09G 1/02*** *(2006.01)* ***C09K 3/14*** *(2006.01)*

(86) International application number:
**PCT/EP2007/062102**

(87) International publication number:
**WO 2008/101553 (28.08.2008 Gazette 2008/35)**

(54) **DISPERSION COMPRISING CERIUM OXIDE AND COLLOIDAL SILICON DIOXIDE**

DISPERSION, ENTHALTEND CEROXID UND KOLLOIDALES SILICIUMOXID

DISPERSION COMPRENANT DE L'OXYDE DE CÉRIUM ET UN DIOXYDE DE SILICIUM COLLOÏDAL

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **20.02.2007 DE 102007008232**

(43) Date of publication of application:
**25.11.2009 Bulletin 2009/48**

(73) Proprietor: **Evonik Degussa GmbH**
**45128 Essen (DE)**

(72) Inventors:
- **KRÖLL, Michael**
**63589 Linsengericht (DE)**
- **HEBERER, Stefan**
**63073 Offenbach (DE)**
- **DAUTH, Katharina**
**63073 Offenbach (DE)**

(56) References cited:
**JP-A- 2006 306 924**
**JP-A- 2006 318 952**
**US-A1- 2003 017 786**
**US-A1- 2006 117 667**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

The invention relates to a dispersion which comprises particles of cerium oxide and of silicon dioxide, and to its production and use.

US 2003/017786 discloses a CMP slurry, comprising a dispersion containing colloidal silica particles having a primary particle diameter falling within a range of 5 nm to 50 nm and ceria particles having a primary particle diameter falling within a range of 50 nm to 100 nm, the concentration of the colloidal silica particles falling within a range of 0.5 to 5% by weight, and the concentration of the ceria particles falling within a range of 0.01 to 0.1% by weight.

US2006/117667 discloses a slurry composition CMP slurry having a pH between about 2 to about 8 comprising at least one oxidizing compound, at least one activator selected activator and silica and/or ceria particles.

JP2006318952 discloses a CMP slurry having a pH of 3 to 6 comprising positively charged ceria particles, a dispersant, a nitrogen-containing heterocyclic compound and water.

JP2006306924 discloses a CMP slurry comprising colloidal silica having a negative zeta potential and a ceria particles having a positive zeta potential at the pH during polishing.

US 5891205 discloses an alkaline dispersion which comprises silicon dioxide and cerium oxide for polishing an oxide layer of a semiconductor device, e.g. semiconductor wafers containing a silica layer. The particle size of the cerium oxide particles is less than or equal to the size of the silicon dioxide particles. The cerium oxide particles present in the dispersion stem from a gas phase process, are not aggregated, and have a particle size which is less than or equal to 100 nm. As a result of the presence of cerium oxide particles and silicon dioxide particles, the material removal rate can be raised sharply according to US 5891205. In order to achieve this, the silicon dioxide/cerium oxide weight ratio should be from 7.5:1 to 1:1. The silicon dioxide preferably has a particle size of less than 50 nm and the cerium oxide a particle size of less than 40 nm. In summary, a) the proportion of silicon dioxide is greater than the proportion of cerium oxide and b) the silicon dioxide particles are larger than the cerium oxide particles.

The dispersion disclosed in US5891205 enables significantly higher material removal than a dispersion based only on cerium oxide particles. Such a dispersion enables significantly higher material removal than a dispersion based only on cerium oxide particles. However, such a dispersion causes a high defect rate.

What are desired are dispersions which afford a high material removal rate with a low defect rate and high selectivity. After the polishing and cleaning of the wafers, only a small amount of deposits, if any, should be present on the surface.

It has now been found that, surprisingly, the object is achieved by a dispersion which comprises cerium oxide particles and colloidal silicon dioxide particles, where

- the zeta potential of the dispersion is negative overall, and
- the mean particle diameter of the cerium oxide particles is not more than 200 nm and that of the silicon dioxide particles is not more than 100 nm, the mean particle diameter of the cerium dioxide particles being greater than that of the silicon dioxide particles,
- the cerium oxide/silicon dioxide weight ratio is from 1.1:1 to 100:1 and
- the content of cerium oxide is from 0.01 to 50% by weight and colloidal silicon dioxide is from 0.01 to 10% by weight, each based on the dispersion and
- the pH of the dispersion is from 7.5 to 10.5

obtainable by

a) introducing and subsequently dispersing cerium oxide particles in powder form into a predispersion comprising colloidal silicon dioxide particles or

b) combining and subsequently dispersing a predispersion comprising cerium oxide particles and a predispersion comprising colloidal silicon dioxide particles, and

c) optionally adding, after the dispersion step of variants a) or b), oxidizing agent, oxidation catalyst and/or corrosion inhibitor,

d) wherein the zeta potential of the colloidal silicon dioxide particles is from -20 to -100 mV and that of the cerium oxide particles is from 0 to 40 mV, each at a pH of from 7.5 to 10.5.

Colloidal silicon dioxide particles are understood to mean those which are present in the form of mutually uncrosslinked, spherical or very substantially spherical individual particles and which are hydroxylated on the surface.

One measure of the surface charge of the particles is the zeta potential. The zeta potential is understood to mean the potential at the shear level within the electrochemical double layer of particle/electrolyte in the dispersion. An important parameter in connection with the zeta potential is the isoelectric point (IEP) for a particle. The IEP specifies the pH at which the zeta potential is zero. The greater the zeta potential, the more stable is the dispersion.

The charge density at the surface can be influenced by changing the concentration of the potential-determining ions in the surrounding electrolyte.

Particles of the same material will have the same sign of the surface charges and thus repel one another. When the zeta potential is too small, the repulsive force, however, cannot compensate for the van der Waals attraction of the particles, and there is flocculation and possibly sedimentation of the particles.

The zeta potential can, for example, be determined by measuring the colloidal vibration current (CVI) of the dispersion or by determining the electrophoretic mobility.

Moreover, the zeta potential can be determined by means of the electrokinetic sound amplitude (ESA).

The inventive dispersion preferably has a zeta potential of from -20 to -100 mV and more preferably a zeta potential of from -25 to -50 mV.

The pH of the inventive dispersion is preferably from 9 to 10.

The proportion of cerium oxide in the inventive dispersion can be varied over a wide range. Preferably, the content of cerium oxide may be from 0.01 to 50% by weight based on the dispersion. High contents are desired when the intention is, for example, to minimize transport costs. The content of cerium oxide is preferably from 0.1 to 5% by weight and more preferably from 0.2 to 1% by weight, based on the dispersion.

The content of colloidal silicon dioxide is preferably from 0.01 to 10% by weight and more preferably from 0.05 to 0.5% by weight, based on the dispersion.

The cerium oxide/silicon dioxide weight ratio in the inventive dispersion is from 1.1:1 to 100:1. It has been found to be advantageous when the cerium oxide/silicon dioxide weight ratio is from 1.25:1 to 5:1.

Moreover, preference may be given to an inventive dispersion in which, apart from cerium oxide particles and colloidal silicon dioxide particles, no further particles are present.

The mean particle diameter of the cerium oxide particles in the inventive dispersion is not more than 200 nm. Preference is given to a range from 40 to 90 nm. Within this range, the best results arise in polishing processes with regard to material removal, selectivity and defect rate.

The cerium oxide particles may be present as isolated individual particles, or else in the form of aggregated primary particles. The inventive dispersion preferably comprises aggregated cerium oxide particles, or the cerium oxide particles are present predominantly or completely in aggregated form.

Particularly suitable cerium oxide particles have been found to be those which contain carbonate groups on their surface and in layers close to the surface, especially those as disclosed in DE-A-102005038136. These are cerium oxide particles which

- have a BET surface area of from 25 to 150 $m^2/g$,
- the primary particles have a mean diameter of from 5 to 50 nm,
- the layer of the primary particles close to the surface has a depth of approx. 5 nm,
- in the layer close to the surface, the carbonate concentration, proceeding from the surface at which the carbonate concentration is at its highest, decreases toward the interior,
- the carbon content on the surface which stems from the carbonate groups is from 5 to 50 area percent and, in the layer close to the surface, is from 0 to 30 area percent in a depth of approx. 5 nm
- the content of cerium oxide, calculated as $CeO_2$ and based on the powder, is at least 99.5% by weight and
- the content of carbon, comprising organic and inorganic carbon, is from 0.01 to 0.3% by weight, based on the powder.

The carbonate groups can be detected both at the surface and in a depth up to approx. 5 nm of the cerium oxide particles. The carbonate groups are chemically bonded and may, for example, be arranged as in the structures a-c.

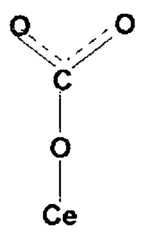
a

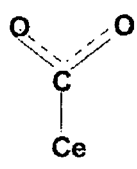
b

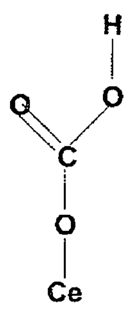
c

The carbonate groups can be detected, for example, by XPS/ESCA analysis. To detect the carbonate groups

in the layer close to the surface, some of the surface can be ablated by means of argon ion bombardment, and the new surface which arises can likewise be analyzed by means of XPS/ESCA (XPS = X-ray Photoelectron Spectroscopy; ESCA = Electron Spectroscopy for Chemical Analysis).

The content of sodium is generally not more than 5 ppm and that of chlorine not more than 20 ppm. The elements mentioned are generally tolerable only in small amounts in chemical-mechanical polishing.

The cerium oxide particles used preferably have a BET surface area of from 30 to 100 $m^2/g$ and more preferably of 40-80 $m^2/g$.

The colloidal silicon dioxide particles of the inventive dispersion have a mean particle diameter preferably from 3 to 50 nm and more preferably from 10 to 35 nm.

The liquid phase of the inventive dispersion comprises water, organic solvents and mixtures of water with organic solvents. In general, the main constituent, with a content of > 90% by weight of the liquid phase, is water.

In addition, the inventive dispersion may also comprise acids, bases, salts. The pH can be adjusted by means of acids or bases. The acids used may be inorganic acids, organic acids or mixtures of the aforementioned. The inorganic acids used may in particular be phosphoric acid, phosphorous acid, nitric acid, sulfuric acid, mixtures thereof, and their acidic salts. The organic acids used are preferably carboxylic acids of the general formula $C_nH_{2n+1}CO_2H$, where n=0-6 or n=8, 10, 12, 14, 16, or dicarboxylic acids of the general formula $HO_2C(CH_2)_nCO_2H$, where n=0-4, or hydroxycarboxylic acids of the general formula $R_1R_2C(OH)CO_2H$, where $R_1$=H, $R_2$=$CH_3$, $CH_2CO_2H$, $CH(OH)CO_2H$, or phthalic acid or salicylic acid, or acidic salts of the aforementioned acids or mixtures of the aforementioned acids and their salts. The pH can be increased by adding ammonia, alkali metal hydroxides or amines.

In particular applications, it may be advantageous when the inventive dispersion contains 0.3-20% by weight of an oxidizing agent. For this purpose, it is possible to use hydrogen peroxide, a hydrogen peroxide adduct, for example the urea adduct, an organic peracid, an inorganic peracid, an imino peracid, a persulfate, perborate, percarbonate, oxidizing metal salts and/or mixtures of the above. More preferably, hydrogen peroxide may be used. Owing to the reduced stability of some oxidizing agents toward other constituents of the inventive dispersion, it may be advisable not to add them until immediately before the utilization of the dispersion.

The inventive dispersion may further comprise oxidation activators. Suitable oxidation activators may be the metal salts of Ag, Co, Cr, Cu, Fe, Mo, Mn, Ni, Os, Pd, Ru, Sn, Ti, V and mixtures thereof. Also suitable are carboxylic acids, nitriles, ureas, amides and esters. Iron(II) nitrate may be particularly preferred. The concentration of the oxidation catalyst may, depending on the oxidizing agent and the polishing task, be varied within a range between 0.001 and 2% by weight. More preferably, the range may be between 0.01 and 0.05% by weight.

The corrosion inhibitors, which are generally present in the inventive dispersion with a content of from 0.001 to 2% by weight, may be nitrogen-containing heterocycles such as benzotriazole, substituted benzimidazoles, substituted pyrazines, substituted pyrazoles and mixtures thereof.

The invention further provides a process in which

a) cerium oxide particles in powder form are introduced and subsequently dispersed into a predispersion comprising colloidal silicon dioxide particles or

b) a predispersion comprising cerium oxide particles and a predispersion comprising colloidal silicon dioxide particles are combined and subsequently dispersed, and

c) optionally, after the dispersion step of variants a) or b), oxidizing agent, oxidation catalyst and/or corrosion inhibitor are added.

Suitable dispersing units are especially those which bring about an energy input of at least 200 $kJ/m^3$. These include systems operating by the rotor-stator principle, for example ultra-turrax machines, or stirred ball mills. Higher energy inputs are possible with a planetary kneader/mixer. However, the efficacy of this system is combined with a sufficiently high viscosity of the processed mixture in order to introduce the required high shear energies to divide the particles.

High-pressure homogenizers are used to decompress two predispersed suspension streams under high pressure through a nozzle. The two dispersion jets meet one another exactly and the particles grind one another. In another embodiment, the predispersion is likewise placed under high pressure, but the particles collide against armored wall regions. The operation can be repeated as often as desired in order to obtain smaller particle sizes.

Moreover, the energy input can also be effected by means of ultrasound.

The dispersion and grinding apparatus can also be used in combination. Oxidizing agents and additives can be supplied at different times to the dispersion. It may also be advantageous, for example, not to incorporate oxidizing agents and oxidation activators until the end of the dispersion, if appropriate at lower energy input.

The zeta potential of the colloidal silicon dioxide particles used is preferably from -20 to -100 mV, at a pH of from 7.5 to 10.5.

The zeta potential of the cerium oxide particles used is preferably from 0 to 40 mV, at a pH of from 7.5 to 10.5.

The invention further provides for the use of the inventive dispersion for polishing.

**Example**

**Analysis**

The specific surface area is determined to DIN 66131.

The surface properties are determined by large-area (1 $cm^2$) XPS/ESCA analysis (XPS = X-ray Photoelectronic Spectroscopy; ESCA = Electron Spectroscopy for Chemical Analysis). The evaluation is based on the general recommendations according to DIN Technical Report No. 39, DMA(A)97 of the National Physics Laboratory, Teddington, U.K., and the findings to date regarding the development-accompanying standardization of the "Surface and Micro Range Analyses" working committee NMP816 (DIN). In addition, the comparative spectra available in each case from the technical literature are taken into account. The values are calculated by background subtraction taking account of the relative sensitivity factors of the electron level reported in each case. The data are in area percent. The precision is estimated at +/- 5% relative.

The zeta potential is determined in the pH range of 3-12 by means of the electrokinetic sound amplitude (ESA). To this end, a suspension comprising 1% cerium oxide is prepared. The dispersion is effected with an ultrasound probe (400 W). The suspension is stirred with a magnetic stirrer and pumped by means of a peristaltic pump through the PPL-80 sensor of the Matec ESA-8000 instrument. From the starting pH, the potentiometric titration with 5M NaOH commences up to pH 12. The back-titration to pH 4 is undertaken with 5M $HNO_3$. The evaluation is effected by means of the instrument software version pcava 5.94.

$$\zeta = \frac{ESA \cdot \eta}{\phi \cdot \Delta\rho \cdot c \cdot |G(\alpha)| \cdot \varepsilon \cdot \varepsilon}$$

where

| | |
|---|---|
| $\xi$ | is zeta potential |
| $\phi$ | is volume fraction |
| $\Delta\rho$ | is density difference between particles and liquid |
| c | is speed of sound in the suspension |
| $\eta$ | is viscosity of the liquid |
| $\varepsilon$ | is dielectric constant of the suspension |
| $\|G(\alpha)\|$ | is correction for inertia. |

The mean aggregate diameters are determined with a Horiba LB-500 particle size analyzer.

**Feedstocks**

The feedstocks used to prepare dispersions are a pyrogenic cerium oxide as described in DE-A-102005038136, example 2 and the colloidal silicon dioxide used is two Levasil® types from H.C. Starck.

**Table 1: Feedstocks**

| | BET | Zeta potential | Particle diameter[a)] |
|---|---|---|---|
| | $m^2/g$ | mV | nm |
| Cerium oxide | 60 | 5 (9.5) | 65 |
| Levasil® 300 | 300 | -31 (9.5) | 13 |
| Levasil® 500 | 500 | -35 (9.5) | 23 |
| a) determined Horiba LB-500 particle size analyzer | | | |

The cerium oxide additionally has the following values: 99.79% by weight of $CeO_2$, 0.14% by weight of C, zeta potential 48 mV at pH = 5, IEP at pH = 9.8, C1s s synthesized/sputtered 19.0/11.2 area% (sputtered: after ablation of the surface by bombardment with argon ions, 5 keV, approx. 10 min; carbonate C: binding energy approx. 289 eV).

**Wafer/pad:**

Silicon dioxide (200 mm, layer thickness 1000 nm, thermal oxide, from SiMat) and silicon nitride (200 mm, layer thickness 160 nm, LPCVD, from SiMat).
Rodel IC 1000-A3 pad.

**Preparation of the dispersions**

D1: The dispersion is obtained by adding cerium oxide powder to water, and dispersing it by ultrasound treatment with an ultrasound finger (from Bandelin UW2200/DH13G, level 8, 100%; 5 minutes). Subsequently, the pH is adjusted to 7.5 with aqueous ammonia.

D2-D5: The dispersions are obtained by mixing a predispersion consisting of cerium oxide and water and a predispersion consisting of colloidal silicon dioxide and water, dispersing it by ultrasound treatment with an ultrasound finger (from Bandelin UW2200/DH13G, level 8, 100%; 5 minutes) and subsequently and adjusting the pH to 9.5 with aqueous ammonia. Table 2 shows important parameters of the resulting dispersions.

**Table 2: Dispersions**

| Dispersion | | D1 | D2 | D3 | D4 | D5 |
|---|---|---|---|---|---|---|
| Cerium oxide | % by wt. | 0.5 | 0.5 | 0.5 | 0.5 | 0.5 |
| Colloidal $SiO_2$ | % by wt. | -<br>0 | Levasil® 300<br>0.18 | Levasil® 300<br>0.325 | Levasil® 500<br>0.125 | Levasil® 500<br>0.175 |
| pH | | 7.5 | 9.5 | 9.5 | 9.5 | 9.5 |
| Zeta potential | mV | 27 | -33 | -22 | -35 | -22 |
| Particle diameter* 0d | nm | 65 | 75 | 266 | 87 | 114 |
| Particle diameter* 7d | nm | - | 95 | - | 87 | - |
| Particle diameter* 44d | nm | - | 81 | | 101 | - |
| * weighted by number of particles; a) determined Horiba LB-500 particle size analyzer | | | | | | |

**Table 3: Polishing results**

| Dispersion | | | D1 | D2 | D4 |
|---|---|---|---|---|---|
| RR $SiO_2$ | nm/min | after | 295 | 195 | 220 |
| RR $Si_3N_4$ | nm/min | makeup | 88 | 84 | 92 |
| $SiO_2/Si_3N_4$ | | | 3.4 | 2.3 | 2.4 |
| | | | | | |
| RR $SiO_2$ | nm/min | | - | 169 | 138 |
| RR $Si_3N_4$ | nm/min | after 14 d | - | 80 | 101 |
| $SiO_2/Si_3N_4$ | | | - | 2.1 | 1.4 |
| | | | | | |
| RR $SiO_2$ | nm/min | | - | 220 | 245 |
| RR $Si_3N_4$ | nm/min | after 44 d | - | 92 | 92 |
| $SiO_2/Si_3N_4$ | | | - | 2.4 | 2.7 |

Table 3 shows the polishing ablations and selectivities after makeup of the dispersions, after 14 and after 44

days. The use of the inventive dispersions leads to a reduction in the ablation rate compared to a dispersion not containing any silicon dioxide particles (D1). However, this is still considered to be satisfactory compared to known dispersions comprising organic additives from the prior art.

Assessment of polishing residues on wafers and pads

The polishing residues are assessed visually (also by light microscope in the range of up to 64-fold magnification).

To this end, the particle sizes of dispersions D1 (comparative) and D2, D4 (inventive) are analyzed directly after polishing:

- D1 is unstable and sediments as early as after a few minutes. The particle size measured is significantly above one micrometer.
- D2, D4, in contrast, are still stable even after polishing. This means that there is no formation of large agglomerates in the case of the inventive dispersions. The wafer polished with D2, D4 also exhibits a considerably lower level of residues.

The addition of negatively charged colloidal silicon dioxide particles influences the polishing quality of a cerium oxide-comprising dispersion in a positive manner by reducing the proportion of polishing residues.

One possible mechanism comprises the outward screening of positively charged cerium oxide particles by negatively charged colloidal silicon dioxide particles, ensuring effective reversal of the charge of the cerium oxide particles. As a result of this reversal of charge, the inventive dispersion offers, inter alia, the possibility of polishing at pH values close to the IEP of the pure cerium oxide. Since the interactions are electrostatic interactions, the colloidal silicon dioxide particles can be sheared off during the polishing operation, so that the polishing action of the cerium oxide is maintained. As a result of all particles always being outwardly negatively charged during the entire polishing operation, agglomerate formation is significantly reduced. Long-term analyses show that the stability and polishing properties are maintained even over prolonged periods.

## Claims

**1.** A dispersion comprising cerium oxide particles and colloidal silicon dioxide particles, where

- the zeta potential of the dispersion is negative overall, and
- the mean particle diameter of the cerium oxide particles is not more than 200 nm and that of the silicon dioxide particles is not more than 100 nm, the mean particle diameter of the cerium dioxide particles being greater than that of the silicon dioxide particles,
- the cerium oxide/silicon dioxide weight ratio is from 1.1:1 to 100:1 and
- the content of
cerium oxide is from 0.01 to 50% by weight,
colloidal silicon dioxide is from 0.01 to 10% by weight, each based on the dispersion and
- the pH of the dispersion is from 7.5 to 10.5
obtainable by

a) introducing and subsequently dispersing cerium oxide particles in powder form into a predispersion comprising colloidal silicon dioxide particles or
b) combining and subsequently dispersing a predispersion comprising cerium oxide particles and a predispersion comprising colloidal silicon dioxide particles, and
c) optionally adding, after the dispersion step of variants a) or b), oxidizing agent, oxidation catalyst and/or corrosion inhibitor,
d) wherein the zeta potential of the colloidal silicon dioxide particles is from -20 to -100 mV and that of the cerium oxide particles is from 0 to 40 mV, each at a pH of from 7.5 to 10.5.

**2.** The dispersion as claimed in claim 1, wherein the zeta potential of the dispersion is from -20 to -100 mV.

**3.** The dispersion as claimed in claims 1 or 2, wherein the pH is from 9 to 10.

**4.** The dispersion as claimed in claims 1 to 3, wherein the cerium oxide/silicon dioxide weight ratio is from 1.25:1 to 5:1.

5. The dispersion as claimed in claims 1 to 4, wherein the mean particle diameter of the cerium oxide particles is from 40 to 90 nm.

6. The dispersion as claimed in claims 1 to 5, wherein the colloidal silicon dioxide particles have a mean particle diameter of from 3 to 50 nm.

7. The dispersion as claimed in claims 1 to 6, wherein water is the main constituent of the liquid phase of the dispersion.

8. The dispersion as claimed in claims 1 to 7, which comprises acids, bases and/or salts.

9. A process for producing the dispersion as claimed in claims 1 to 8, which comprises

a) introducing and subsequently dispersing cerium oxide particles in powder form into a predispersion comprising colloidal silicon dioxide particles or
b) combining and subsequently dispersing a predispersion comprising cerium oxide particles and a predispersion comprising colloidal silicon dioxide particles, and
c) optionally adding, after the dispersion step of variants a) or b), oxidizing agent, oxidation catalyst and/or corrosion inhibitor.

10. The process as claimed in claim 9, wherein the zeta potential of the colloidal silicon dioxide particles is from -20 to -100 mV at a pH of from 7.5 to 10.5.

11. The process as claimed in claim 9 or 10, wherein the zeta potential of the cerium oxide particles is from 0 to 40 mV at a pH of from 7.5 to 10.5.

12. The use of the dispersion as claimed in claims 1 to 8 for polishing.

## Patentansprüche

1. Dispersion enthaltend Ceroxidpartikel und kolloidale Siliciumdioxidpartikel, wobei

- das Zetapotential der Dispersion insgesamt negativ ist, und
- der mittlere Partikeldurchmesser der Ceroxidpartikel maximal 200 nm und der der Siliciumdioxidpartikel maximal 100 nm ist, wobei der mittlere Partikeldurchmesser der Ceroxidpartikel größer ist als der der Siliciumdioxidpartikel,
- das Gewichtsverhältnis Ceroxid/Siliciumdioxid 1,1:1 bis 100:1 ist und
- der Anteil an
Ceroxid 0,01 bis 50 Gew.-%,
kolloidalem Siliciumdioxid 0,01 bis 10 Gew.-%, jeweils bezogen auf die Dispersion, ist und
- der pH-Wert der Dispersion 7,5 bis 10,5 ist, dadurch erhältlich, dass man

a) in eine kolloidale Siliciumdioxidpartikel enthaltende Vordispersion Ceroxidpartikel in Pulverform einbringt und nachfolgend dispergiert oder
b) eine Ceroxidpartikel enthaltende Vordispersion und eine kolloidale Siliciumdioxidpartikel enthaltende Vordispersion zusammengibt und nachfolgend dispergiert und
c) gegebenenfalls nach dem Dispergierschritt der Varianten a) oder b) Oxidationsmittel, Oxidationskatalysator und/oder Korrosionsinhibitor hinzufügt,
d) wobei das Zetapotential der kolloidalen Siliciumdioxidpartikel -20 bis -100 mV und das der Ceroxidpartikel 0 bis 40 mV, jeweils bei einem pH-Wert von 7,5 bis 10,5, ist.

2. Dispersion nach Anspruch 1, **dadurch gekennzeichnet, dass** das Zetapotential der Dispersion -20 bis -100 mV ist.

3. Dispersion nach den Ansprüchen 1 oder 2, **dadurch gekennzeichnet, dass** der pH-Wert 9 bis 10 ist.

4. Dispersion nach den Ansprüchen 1 bis 3, **dadurch gekennzeichnet, dass** das Gewichtsverhältnis Ceroxid/Siliciumdioxid 1,25:1 bis 5:1 ist.

5. Dispersion nach den Ansprüchen 1 bis 4, **dadurch gekennzeichnet, dass** der mittlere Partikeldurchmesser der Ceroxidpartikel 40 bis 90 nm ist.

6. Dispersion nach den Ansprüchen 1 bis 5, **dadurch gekennzeichnet dass** die kolloidalen Siliciumdioxidpartikel einen mittleren Partikeldurchmesser von 3 bis 50 nm aufweisen.

7. Dispersion nach den Ansprüchen 1 bis 6, **dadurch gekennzeichnet, dass** Wasser der Hauptbestandteil der flüssigen Phase der Dispersion ist.

8. Dispersion nach den Ansprüchen 1 bis 7, die Säuren, Basen und/oder Salze enthält.

9. Verfahren zur Herstellung der Dispersion gemäß den Ansprüchen 1 bis 8, bei dem man

   a) in eine kolloidale Siliciumdioxidpartikel enthaltende Vordispersion Ceroxidpartikel in Pulverform einbringt und nachfolgend dispergiert oder
   b) eine Ceroxidpartikel enthaltende Vordispersion und eine kolloidale Siliciumdioxidpartikel enthaltende Vordispersion zusammengibt und nachfolgend dispergiert und
   c) gegebenenfalls nach dem Dispergierschritt der Varianten a) oder b) Oxidationsmittel, Oxidationskatalysator und/oder Korrosionsinhibitor hinzufügt.

10. Verfahren nach Anspruch 9, **dadurch gekennzeichnet, dass** das Zetapotential der kolloidalen Siliciumdioxidpartikel -20 bis -100 mV bei einem pH-Wert von 7,5 bis 10,5 ist.

11. Verfahren nach Anspruch 9 oder 10, **dadurch gekennzeichnet, dass** das Zetapotential der Ceroxidpartikel 0 bis 40 mV bei einem pH-Wert von 7,5 bis 10,5 ist.

12. Verwerdung der Dispersion gemäß den Ansprüchen 1 bis 8 zum Polieren.

## Revendications

1. Dispersion comprenant des particules d'oxyde de cérium et des particules de dioxyde de silicium colloïdal, dans laquelle

   - le potentiel zêta de la dispersion est globalement négatif, et
   - le diamètre moyen des particules en ce qui concerne les particules d'oxyde de cérium n'est pas supérieur à 200 nm et celui des particules de dioxyde de silicium n'est pas supérieur à 100 nm, le diamètre moyen des particules en ce qui concerne les particules d'oxyde de cérium étant plus grand que celui des particules de dioxyde de silicium,
   - le rapport pondéral oxyde de cérium/dioxyde de silicium est de 1,1:1 à 100:1 et
   - la teneur en
   oxyde de cérium est de 0,01 à 50% en poids,
   dioxyde de silicium colloïdal est de 0,01 à 10% en poids, chacune étant basée sur la dispersion et
   - le pH de la dispersion est de 7,5 à 10,5 susceptible d'être obtenue par

      a) introduction suivie d'une dispersion des particules d'oxyde de cérium sous forme de poudre dans une prédispersion comprenant des particules de dioxyde de silicium colloïdal ou
      b) combinaison suivie d'une dispersion d'une prédispersion comprenant des particules d'oxyde de cérium et d'une prédispersion comprenant des particules de dioxyde de silicium colloïdal, et
      c) éventuellement addition, après l'étape de dispersion des variantes a) ou b), d'un agent oxydant, d'un catalyseur d'oxydation et/ou d'un inhibiteur de corrosion,
      d) dans laquelle le potentiel zêta des particules de dioxyde de silicium colloïdal est de -20 à -100 mV et celui des particules d'oxyde de cérium est de 0 à 40 mV, chacun à un pH de 7,5 à 10,5.

2. Dispersion selon la revendication 1, dans laquelle le potentiel zêta de la dispersion est de -20 à -100 mV.

3. Dispersion selon les revendications 1 ou 2, dans laquelle le pH est de 9 à 10.

4. Dispersion selon les revendications 1 à 3, dans laquelle le rapport pondéral oxyde de cérium/dioxyde de silicium est de 1,25:1 à 5:1.

5. Dispersion selon les revendications 1 à 4, dans laquelle le diamètre moyen des particules en ce qui concerne les particules d'oxyde de cérium est de 40 à 90 nm.

6. Dispersion selon les revendications 1 à 5, dans laquelle les particules de dioxyde de silicium colloïdal ont un diamètre moyen des particules de 3 à 50 nm.

7. Dispersion selon les revendications 1 à 6, dans laquelle l'eau est le principal constituant de la phase liquide de la dispersion.

8. Dispersion selon les revendications 1 à 7, qui comprend des acides, des bases et/ou des sels.

9. Procédé de production de la dispersion selon les revendications 1 à 8, qui comprend

a) l'introduction suivie d'une dispersion des particules d'oxyde de cérium sous forme de poudre dans une prédispersion comprenant des particules de dioxyde de silicium colloïdal ou
b) la combinaison suivie d'une dispersion d'une prédispersion comprenant des particules d'oxyde de cérium et d'une prédispersion comprenant des particules de dioxyde de silicium colloïdal, et
c) éventuellement l'addition, après l'étape de dispersion des variantes a) ou b), d'un agent oxydant, d'un catalyseur d'oxydation et/ou d'un inhibiteur de corrosion.

10. Procédé selon la revendication 9, dans lequel le potentiel zêta des particules de dioxyde de silicium colloïdal est de -20 à -100 mV à un pH de 7,5 à 10,5.

11. Procédé selon la revendication 9 ou 10, dans lequel le potentiel zêta des particules d'oxyde de cérium est de 0 à 40 mV à un pH de 7,5 à 10,5.

12. Utilisation de la dispersion selon les revendications 1 à 8 pour polir.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2003017786 A
- US 2006117667 A
- JP 2006318952 B
- JP 2006306924 B
- US 5891205 A
- DE 102005038136 A